# EUROPEAN PATENT SPECIFICATION

(11) **EP 2 030 083 B1**
(45) Date of publication and mention of the grant of the patent: **18.09.2013**
(21) Application number: 07733719.4
(22) Date of filing: 25.05.2007
(51) Int. Cl.: G03F 7/20

(54) **METHOD OF CONTROLLING CONTAMINATION OF A SURFACE**
VERFAHREN ZUR VERUNREINIGUNGSKONTROLLE EINER OBERFLÄCHE
MÉTHODE DE CONTRÔLE DE LA CONTAMINATION D'UNE SURFACE

(30) Priority: 13.06.2006 GB 0611648
(43) Date of publication of application: 04.03.2009
(73) Proprietor: Edwards Limited, Crawley, West Sussex RH10 9LW (GB); Cambridge Enterprise Limited, Trinity Lane Cambridge Cambridgeshire CB2 1TN (GB)
(72) Inventor: GRANT, Robert Bruce, Crawley Sussex RH10 2LW (GB); LAMBERT, Richard, Cambridge Cambridgeshire CG2 1EW (GB); DAVIS, David Jonathan, Cambridge Cambridgeshire CG2 1EW (GB); KYRIAKOU, Georgios, Cambridge Cambridgeshire CG2 1EW (GB)
(74) Representative: Clark, Charles Robert
(86) International application number: PCT/GB2007/050298
(87) International publication number: WO 2007/144666

(56) References cited:
- WO-A-2004/095136
- WO-A-2004/099878
- JP-A- 11 095 413
- US-A1- 2001 053 414

## Description

The invention relates to a method of controlling contamination of a surface. The methods finds particular use in controlling the contamination of the surfaces located in a chamber exposed to ionising radiation in the presence of a hydrocarbon contaminant.

Photolithography is an important process step in semiconductor device fabrication. In overview, in photolithography a circuit design is transferred to a wafer through a pattern imaged on to a photoresist layer deposited on the wafer surface. The wafer then undergoes various etch and deposition processes before a new design is transferred to the wafer surface. This cyclical process continues, building up the multiple layers of the semiconductor device.

In lithographic processes used in the manufacture of semiconductor devices, it is advantageous to use radiation of very short wavelength in order to improve optical resolution so that very small features in the device may be accurately reproduced. In the prior art, monochromatic visible light of various wavelengths have been used, and more recently radiation in the deep ultra violet (DUV) range has been used, including radiation at 248 nm, 193 nm and 157 nm. In order to further improve optical resolution, it has also been proposed to use radiation in the extreme ultra violet (EUV) range, including radiation at 13.5 nm.

EUV radiation has poor transmissibility through all materials and gases at atmospheric pressures, and therefore much of the mechanical, electrical and optical equipment located in the lithography tool must be operated in a high-purity vacuum environment. The source of EUV radiation is typically housed within a chamber located adjacent the lithography tool. In order to isolate the radiation source from the lithography tool, a thin foil, usually formed from zirconium, nickel or silicon, is often used as a window through which EUV radiation is transmitted into the lithography tool. In addition to separating the tool from the radiation source, the foil can act as a spectral purity filter (SPF) by restricting the bandwidth of frequencies of electromagnetic radiation entering the tool.

The source of EUV radiation may be based on excitation of tin, lithium, or xenon. For example, when xenon is used in the EUV source, a xenon plasma is generated, either by stimulating xenon by an electrical discharge or by intense laser illumination.

Electromagnetic radiation, such as EUV radiation or X-rays, can promote the deposition of carbonaceous deposits on the surfaces of lenses or mirrors used to direct and focus DUV or EUV radiation towards a wafer surface. This radiation stimulates the emission of secondary electrons from these surfaces, which electrons interact with carbonaceous contaminants, typically hydrocarbon species, present within the lithography tool to form these carbonaceous deposits. These hydrocarbon species may originate from the wafer being processed within the lithography tool, for example from photoresist or photoresist by-products.

This carbonaceous deposition can result in the clouding of lenses, or the loss of reflectivity of mirrors, leading to reduced illumination and consequent loss of tool productivity. Due to the high cost of these optical components, it is always undesirable to replace them, and in many cases it is completely impractical.

A conventional technique for mitigating against these problems is to operate the tool in an ultra clean environment, thereby reducing the partial pressure of the contaminating hydrocarbon species, and bringing the rate of carbonaceous film growth on the surfaces of the chamber to an acceptable level. Additional vacuum pumping capacity may be provided to a vacuum based lithography tool to maintain the hydrocarbon partial pressure within desirable limits. However, in practice such environments can be difficult to achieve and maintain, and can add significant cost to the lithography tool.

Another alternative is to control the growth of the carbonaceous films by chemical means. For example, US 2002/0083409 describes a method for controlling the build up of carbonaceous deposits on reflective mirror surfaces by the addition of oxygen to the vacuum surrounding the mirror surfaces. The addition of oxygen causes the carbonaceous films to be combusted to gaseous CO₂, and potentially also H₂O depending on the film composition. However, such a technique needs to be carefully monitored to avoid damage of the mirror surfaces due to oxidation of the exposed mirror surfaces by the oxygen supplied to the chamber.

WO2004099878 discloses an EUV system that uses a reflective element covered with a transition metal layer together with the introduction of a reducing gas as well as a gas having oxygen atoms.

The present invention provides a method of controlling contamination of a surface exposed to a carbonaceous material and ionising radiation, characterised in that the method comprises cyclically supplying to said surface a first gas containing an oxidising species for reacting with carbonaceous deposits formed on the surface from the carbonaceous material, followed by a second gas containing a reducing species for reacting with oxidising species on said surface.

The present invention can thus provide a relatively simple method of removing carbonaceous deposits from a surface whilst preventing the build up of oxide on the exposed surface and without the need to provide expensive or complex systems for monitoring the surface condition.

Examples of a suitable oxidising species include O₂, NO, N₂O, H₂O₂ and OF₂, and examples of a suitable reducing species include CO, H₂, NH₃ and N₂H₄.

The relative durations of the supply of the first and second gases are different. The duration of the supply of the first gas is preferably longer than the duration of the supply of the second gas, for example by at least five times. One preferred ratio of these durations is 10:1. By controlling the relative durations of the supply of these species to the surface, the growth of carbonaceous deposits on the surface can be inhibited whilst preventing the build up of oxide of the surface.

The supply of reducing species to the surface can also be used to control oxide film growth on a surface exposed to ionising radiation due to the presence of moisture or other oxidising species, and so the present invention also provides a method of inhibiting oxidation of surface exposed to a gaseous oxidising species and ionising radiation, the method comprising supplying to the surface a reducing species for reacting with oxidising species on the surface

In the preferred embodiment, the ionising radiation is generated by a radiation source in the form of a plasma. A number of different materials may be used as the source of the plasma, for example, one of lithium, tin and xenon for the generation of EUV radiation. Alternatively, the source may generate radiation through impact of electrons on a metal surface. For example, X-rays may be generated through the impact of electrons on an aluminium or magnesium surface. The ionising radiation may also comprise electrons, for example, within an electron bean used to inspect a surface.

The method is particularly suitable for cleaning surfaces within a lithography tool, for example the surface of a substrate, filter, optical element, such as multi-layer mirror or lens, and so the present invention also provides a method of in situ cleaning of a surface within a lithography tool, comprising a method as aforementioned for controlling contamination of the surface.

The present invention further provides an apparatus for controlling contamination of a surface exposed to a carbonaceous material and ionising radiation, wherein the apparatus comprises:
means for cyclically supplying to the surface a first gas containing an oxidising species for reacting with carbonaceous deposits formed on the surface from the carbonaceous material, followed by a second gas containing a reducing species for reacting with oxidising species on said surface; further comprising a first mass flow controller for controlling the duration and the rate of supply of the first gas, and a second mass flow controller for controlling the duration and the rate of supply of the second gas;
and characterised in that the apparatus further comprises a controller means for controlling the operation of the mass flow controllers and configured to control the duration of the supply of the first and second gases such that the supply of the first gas is longer, preferably at least five times longer, than the duration of the supply of the second gas.

Other aspects of the invention include apparatus comprising a tool housed in a chamber, the tool comprising at least one surface for directing ionising radiation towards a substrate, and apparatus as aforementioned for controlling contamination of the surface, and apparatus comprising a tool housed in a chamber, the tool comprising at least one surface for directing ionising radiation towards a substrate, and means for supplying to the surface a reducing species for reacting with an oxidising species on the surface.

Features described above in relation to method aspects of the invention are equally applicable to apparatus aspects, and vice versa.

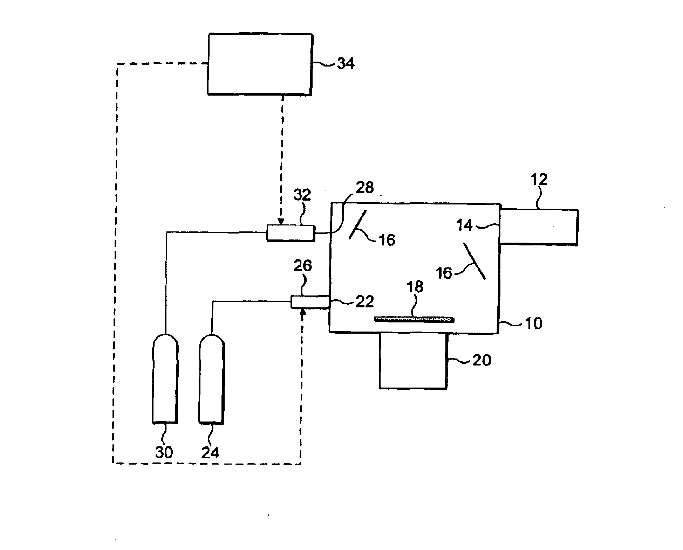

By way of example, an embodiment of the invention will now be further described with reference to the accompanying figure, which illustrates schematically an example of a lithography apparatus which comprises a lithography chamber 10 and a source 12 of electromagnetic radiation, in this example EUV radiation, optically linked to the chamber 10. The source 12 may be a discharge plasma source or a laser-produced plasma source. In a discharge plasma source, a discharge is created in a medium between two electrodes, and a plasma created from the discharge emits EUV radiation. In a laser-produced plasma source, a target is converted to a plasma by an intense laser beam focused on the target. A suitable medium for a discharge plasma source and for a target for a laser-produced plasma source is xenon, as xenon plasma radiates EUV radiation at a wavelength of 13.5 nm. However, other materials, such as lithium and tin, may be used as the target material, and so the present invention is not limited to the particular material or mechanism used to generate EUV radiation. The invention is also applicable to apparatus using other forms of ionising or electromagnetic radiation. For example, the source 12 may be a source of X-rays, in which X-rays are produced by the impact of electrons on a metal surface, for example Al or Mg, a source of DUV radiation, or a source of electrons.

Returning to the illustrated embodiment, EUV radiation generated by the source 12 is supplied to the chamber 10 via, for example, one or more windows 14 located in the wall of the chamber 10. The window 14 may be provided by a spectral purity filter (SPF) comprising a very thin foil, typically formed from zirconium, nickel or silicon, for transmitting EUV radiation into the chamber 10 whilst preventing contaminants from entering the chamber 10 from the source 12.

The chamber 10 houses a lithography tool, which comprises a system of optical elements such as lenses or multi-layer mirrors (MLMs) 16 which generate a radiation beam for projection on to a mask or reticle for the selective illumination of a photoresist on the surface of a substrate, such as a semiconductor wafer 18. MLMs comprise a plurality of layers, each layer comprising, from the bottom a first layer of molybdenum and a second layer of silicon. A metallic layer, preferably formed from ruthenium, is formed on the upper surface of each MLM to improve the oxidation resistance of the MLMs whilst reflecting substantially all of the in-band radiation incident thereon.

Due to the poor transmissibility of EUV radiation through most gases, a vacuum pumping system 20 is provided for generating a vacuum within chamber 10. In view of the complex variety of gases and contaminants, such as water vapour and hydrocarbons, which may be present in chamber 10, the pumping system for chamber 10 may include both a cryogenic vacuum pump and a transfer pump, such as a turbomolecular pump, backed by a roughing pump. Such a combination of pumps can enable a high vacuum to be created in the chamber 10.

As mentioned earlier, in the presence of EUV radiation, secondary electrons are released from within the surfaces of the MLMs, which electrons interact with contaminants on the surfaces, reducing their reflectivity. Cracking of adsorbed hydrocarbon contaminants can form graphitic type carbon layers adhering to the MLMs, with the resulting loss of reflectivity leading to reduced illumination and consequent loss of tool productivity. For example, a hydrocarbon having the general formula CₓH_{y} dissociates in the presence of EUV radiation as per equation (1) below:

CₓH_{y} + e⁻ → CₓH_{y-1} + H(a) + e⁻ → CₓH_{y-2} + H(a) + e⁻ → xC + yH(a) (1)

with deposition (adsorption) of x amount of carbon on surfaces within the chamber 10. This can result in the loss of reflectivity of MLMs, and the clouding of lenses.

In order to inhibit the formation of the carbonaceous deposits on the surfaces within the chamber 10, a first gas containing oxidising species, for example one of O₂, NO, N₂O, H₂O₂ and OF₂, for reacting with carbonaceous deposits formed on the surfaces within the chamber 10 is supplied to the chamber 10. As such oxidising species may also oxidise the surfaces from which the carbonaceous deposits are removed, the supply of oxidising species is followed by the supply to the chamber 10 of a second gas containing a reducing species, for example one of CO, H₂, NH₃ and N₂H₄, for reacting with oxidising species on the surface to prevent the build up of oxide layers on these surfaces. The supply of these two gases is cyclically repeated.

Returning to the drawing, the chamber 10 has a first inlet 22 through which the first gas enters the chamber 10 from source 24. A mass flow controller 26 controls the duration and the rate of supply of the first gas into the chamber 10. In this embodiment, the chamber 10 also has a second inlet 28 through which the second gas enters the chamber 10 from source 30, with a second mass flow controller 32 controlling the duration and the rate of supply of the second gas into the chamber 10. Alternatively, the first and second gases may be supplied to the chamber 10 through a common inlet.

A controller 34 is provided for controlling the operation of the mass flow controllers 26, 32. The relative durations of the supply of the first and second gases are different. The duration of the supply of the first gas is preferably longer than the duration of the supply of the second gas, with the ratio of the duration of supply of the first and second gases to the chamber 10 being between 1:1 and 100:1 depending on the nature of the oxidising and reducing species, and the conditions at the surfaces of the optical elements. By controlling the relative durations of the supply of these species to the surfaces, the growth of carbonaceous deposits on the surfaces can be inhibited whilst preventing the build up of oxide of the clean surfaces.

The oxidising and reducing species are preferably chosen so that the rate of reduction of oxidising species on the clean surfaces by the reducing species is very fast, so that there is substantially no oxygen diffusion into the surfaces or oxide formation, and so that the rate of oxidation of the reducing species by the oxidising species on the contaminated surface is significantly slower than the rate of oxidation of the carbonaceous deposits, so that there is substantially no carbon formation on the surfaces. The oxidising and reducing species are preferably chosen so that both species are pumped by the vacuum pumping system 20 to substantially the same degree. In one example, the gases supplied to the chamber comprises NO and CO.

## Claims

1. A method of controlling contamination of a surface (16) exposed to a carbonaceous material and ionising radiation, **characterised in that** the method comprises cyclically supplying to said surface a first gas containing an oxidising species for reacting with carbonaceous deposits formed on the surface from the carbonaceous material, followed by a second gas containing a reducing species for reacting with oxidising species on said surface.

2. A method according to Claim 1, wherein the method comprises supplying either oxidising species comprising one of O₂, NO, N₂O, H₂O₂ and OF₂, or reducing species comprising one of CO, H₂, NH₃ and N₂H₄.

3. A method according to any preceding claim, wherein the rate of oxidation of the reducing species by the oxidising species on the contaminated surface is slower than the rate of oxidation of the carbonaceous deposits by the oxidising species.

4. A method according to any preceding claim, wherein the relative durations of the supply of the first and second gases are different.

5. A method according to Claim 4, wherein the duration of the supply of the first gas is longer, preferably at least five times longer, than the duration of the supply of the second gas.

6. A method of in situ cleaning of a surface within a lithography tool, comprising a method according to any preceding claim for controlling contamination of the surface.

7. A method according to Claim 6, wherein the surface is a surface of an optical element, or wherein the surface is a surface of an optical element comprising one of a lens, a multi-layer mirror and spectral purity filter.

8. Apparatus for controlling contamination of a surface (16) exposed to a carbonaceous material and ionising radiation, wherein the apparatus comprises: means (32, 26) for cyclically supplying to the surface a first gas containing an oxidising species for reacting with carbonaceous deposits formed on the surface from the carbonaceous material, followed by a second gas containing a reducing species for reacting with oxidising species on said surface; further comprising first a mass flow controller 26 for controlling the duration and the rate of supply of the first gas, and a second mass flow controller 32 for controlling the duration and the rate of supply of the second gas; and **characterised in that** the apparatus further comprises a controller means (34) for controlling the operation of the mass flow controllers (26, 32) and configured to control the duration of the supply of the first and second gases (24, 30) such that the supply of the first gas is longer, preferably at least five times longer, than the duration of the supply of the second gas.

9. Apparatus according to Claim 8 wherein the oxidising species comprises one of O₂, NO, N₂O, H₂O₂ and OF₂, and wherein the reducing species comprises one of CO, H₂, NH₃ and N₂H₄

10. Apparatus comprising a tool housed in a chamber, the tool comprising at least one surface (16) for directing ionising radiation (12) towards a substrate (18), and apparatus according to any of Claims 8 to 9 for controlling contamination of the surface.

11. Apparatus according to Claim 10, wherein the surface (16) is a surface of an optical element, or wherein the surface is a surface of an optical element comprising one of a lens, a multi-layer mirror and a spectral purity filter.

12. Lithography apparatus comprising a lithography tool housed in a chamber for receiving a substrate to be exposed to ionising radiation, and apparatus according to any of Claims 8 to 11 for controlling contamination of the surface of the substrate.

13. Inspection apparatus comprising an inspection tool housed in a chamber for receiving a sample to be inspected by exposure to ionising radiation, and apparatus according to any of Claims 8 to 12 for controlling contamination of the surface of the sample.

14. Apparatus according to any of Claims 8 to 13, wherein the ionising radiation comprises one of EUV radiation, DUV radiation and electrons.

## Patentansprüche

1. Verfahren zur Beherrschung der Kontaminierung einer Oberfläche (16), die einem kohlenstoffhaltigen Material und ionisierender Strahlung ausgesetzt ist, **dadurch gekennzeichnet, dass** das Verfahren das zyklische Zuführen eines ersten Gases zu der genannten Oberfläche umfasst, das eine oxidierende Spezies zum Reagieren mit kohlenstoffhaltigen Ablagerungen enthält, die aus den kohlenstoffhaltigen Material auf der Oberfläche gebildet sind, gefolgt von einem zweiten Gas, das eine reduzierende Spezies zum Reagieren mit oxidierenden Spezien auf der genannten Oberfläche enthält.

2. Verfahren nach Anspruch 1, wobei das Verfahren das Zuführen entweder oxidierender Spezien, die eines von O₂, NO, N₂O, H₂O₂ und OF₂ umfassen, oder reduzierender Spezien aufweist, die eines von CO, H₂, NH₃ und N₂H₄ umfassen.

3. Verfahren nach irgendeinem vorhergehenden Anspruch, wobei die Oxidationsrate der reduzierenden Spezien durch die oxidierenden Spezien auf der kontaminierten Oberfläche langsamer als die Oxidationsrate der kohlenstoffhaltigen Ablagerungen durch die oxidierenden Spezien ist.

4. Verfahren nach irgendeinem vorhergehenden Anspruch, wobei die relative Dauer der Zufuhr des ersten Gases und des zweiten Gases verschieden ist.

5. Verfahren nach Anspruch 4, wobei die Dauer der Zufuhr des ersten Gases länger, vorzugsweise mindestens fünfmal länger, als die Dauer der Zufuhr des zweiten Gases ist.

6. Verfahren zur Reinigung einer Oberfläche an Ort und Stelle mit einem Lithographiewerkzeug, das ein Verfahren nach irgendeinem vorhergehenden Anspruch zur Beherrschung der Kontaminierung der Oberfläche umfasst.

7. Verfahren nach Anspruch 6, wobei die Oberfläche eine Oberfläche eines optischen Elements ist, oder wobei die Oberfläche eine Oberfläche eines optischen Elements ist, das eine Linse, ein Mehrschichtspiegel oder ein Spektralreinheitsfilter ist.

8. Einrichtung zur Beherrschung der Verunreinigung einer Oberfläche 16, die einen kohlenstoffhaltigen Material und ionisierender Strahlung ausgesetzt ist, wobei die Einrichtung Mittel (32, 26) zum zyklischen Zuführen eines ersten Gases zu der Oberfläche hat, das eine oxidierende Spezies zum Reagieren mit auf der Oberfläche durch das kohlenstoffhaltige Material gebildeten kohlenstoffhaltigen Ablagerungen enthält, gefolgt von einem zweiten Gas, das eine reduzierende Spezies zum Reagieren mit oxidierenden Spezien auf der Oberfläche enthält, weiter mit einem ersten Massenströmungsregler (26) zur Steuerung der Dauer und der Zufuhrrate des ersten Gases, und einem zweiten Massenströmungsregler (32) zur Steuerung der Dauer und der Zufuhrrate des zweiten Gases, **dadurch gekennzeichnet, dass** die Einrichtung weiter einen Regler (34) zur Steuerung des Betriebs der Massenströmungsregler (26, 32) aufweist, die so konfiguriert sind, dass sie die Dauer der Zufuhr des ersten und des zweiten Gases (24, 30) derart steuern, dass die Zufuhr des ersten Gases länger, vorzugsweise mindestens fünfmal länger, als die Dauer der Zufuhr des zweiten Gases ist.

9. Einrichtung nach Anspruch 8, wobei die oxidierende Spezies eines von O₂, NO, N₂O, H₂O₂ und OF₂ ist, und wobei die reduzierende Spezies eines von CO, H₂, NH₃, N₂H₄ ist.

10. Einrichtung, die ein in einer Kammer untergebrachtes Werkzeug umfasst, wobei das Werkzeug mindestens eine Oberfläche (16) zum Richten ionisierender Strahlung (12) zu einem Substrat (18) aufweist und eine Einrichtung nach einem der Ansprüche 8 bis 9 zur Beherrschung der Kontaminierung der Oberfläche umfasst.

11. Einrichtung nach Anspruch 10, wobei die Oberfläche (16) eine Oberfläche eines optischen Elements ist, oder wobei die Oberfläche eine Oberfläche eines optischen Elements ist, das eine Linse, einen Mehrschichtspiegel oder ein Spektralreinheitsfilter umfasst.

12. Lithographieeinrichtung mit einem in einer Kammer untergebrachten Lithographiewerkzeug zur Aufnahme eines einer ionisierenden Strahlung auszusetzenden Substrats, und einer Einrichtung nach einem der Ansprüche 8 bis 11 zur Beherrschung der Verunreinigung der Oberfläche des Substrats.

13. Prüfeinrichtung mit einem in einer Kammer untergebrachten Prüfwerkzeug zur Aufnahme einer durch Aussetzen einer ionisierenden Strahlung zu prüfenden Probe und einer Einrichtung nach einem der Ansprüche 8 bis 12 zur Beherrschung der Verunreinigung der Oberfläche der Probe.

14. Einrichtung nach einem der Ansprüche 8 bis 13, wobei die ionisierende Strahlung EUV-Strahlung, DUV-Strahlung oder Elektronen umfasst.

## Revendications

1. Procédé de contrôle de la contamination d'une surface (16) exposée à un matériau carboné et à un rayonnement ionisant, ***caractérisé en ce que*** le procédé comprend la fourniture cyclique à ladite surface d'un premier gaz contenant une espèce oxydante destinée à réagir avec les dépôts carbonés formés sur la surface à partir du matériau carboné, puis d'un deuxième gaz contenant une espèce réductrice destinée à réagir avec les espèces oxydantes sur ladite surface.

2. Procédé selon la revendication 1, dans lequel le procédé comprend la fourniture soit d'espèces oxydantes, comprenant l'un d'entre O₂, NO, N₂O, H₂O₂ et OF₂, soit d'espèces réductrices, comprenant l'un d'entre CO, H₂, NH₃ et N₂H₄.

3. Procédé selon l'une quelconque des revendications précédentes, dans lequel la vitesse d'oxydation des espèces réductrices par les espèces oxydantes sur la surface contaminée est plus lente que la vitesse d'oxydation des dépôts carbonés par les espèces oxydantes.

4. Procédé selon l'une quelconque des revendications précédentes, dans lequel les durées relatives de fourniture du premier et du deuxième gaz sont différentes.

5. Procédé selon la revendication 4, dans lequel la durée de la fourniture du premier gaz est plus longue, de manière préférée au moins cinq fois plus longue, que la durée de la fourniture du deuxième gaz.

6. Procédé de nettoyage *in situ* d'une surface dans un outil de lithographie, comprenant un procédé selon l'une quelconque des revendications précédentes pour contrôler la contamination de la surface.

7. Procédé selon la revendication 6, dans lequel la surface est une surface d'un élément optique, ou dans lequel la surface est une surface d'un élément optique comprenant l'une d'entre une lentille, un miroir multicouche et un filtre de pureté spectrale.

8. Dispositif pour contrôler la contamination d'une surface (16) exposée à un matériau carboné et à un rayonnement ionisant, dans lequel le dispositif comprend des moyens (32, 26) pour fournir à la surface de manière cyclique un premier gaz contenant une espèce oxydante destinée à réagir avec les dépôts carbonés formés sur la surface à partir du matériau carboné, puis un deuxième gaz contenant une espèce réductrice destinée à réagir avec les espèces oxydantes sur ladite surface, comprenant en outre un premier régulateur (26) de débit massique pour contrôler la durée et le débit d'alimentation du premier gaz, et un deuxième régulateur (32) de débit massique pour contrôler la durée et le débit d'alimentation du deuxième gaz ; *et **caractérisé en ce que*** le dispositif comprend en outre des moyens de contrôleur (34) pour contrôler le fonctionnement des régulateurs (26, 32) de débit massique et configurés pour contrôler la durée de fourniture du premier et du deuxième gaz (24, 30) de façon que la fourniture du premier gaz soit plus longue, de manière préférée au moins cinq fois plus longue, que la durée de fourniture du deuxième gaz.

9. Dispositif selon la revendication 8, dans lequel l'espèce oxydante comprend l'un d'entre O₂, NO, N₂O, H₂O₂ et OF₂, et dans lequel l'espèce réductrice, comprend l'un d'entre CO, H₂, NH₃ et N₂H₄.

10. Dispositif comprenant un outil logé dans une chambre, l'outil comprenant au moins une surface (16) pour diriger un rayonnement ionisant (12) vers un substrat (18), et un dispositif selon l'une quelconque des revendications 8 à 9 pour contrôler la contamination de la surface.

11. Dispositif selon la revendication 10, dans lequel la surface (16) est une surface d'un élément optique, ou dans lequel la surface est une surface d'un élément optique comprenant l'un d'entre une lentille, un miroir multi-couche et un filtre de pureté spectrale.

12. Dispositif de lithographie comprenant un outil de lithographie logé dans une chambre destinée à recevoir un substrat à exposer à un rayonnement ionisant, et dispositif selon l'une quelconque des revendications 8 à 11 pour contrôler la contamination de la surface du substrat.

13. Dispositif d'inspection comprenant un outil d'inspection logé dans une chambre destinée à recevoir un échantillon devant être inspecté par exposition à un rayonnement ionisant, et dispositif selon l'une quelconque des revendications 8 à 12 pour contrôler la contamination de la surface de l'échantillon.

14. Dispositif selon l'une quelconque des revendications 8 à 13, dans lequel le rayonnement ionisant comprend l'un parmi rayonnement EUV, rayonnement DUV et électrons.
